# EUROPEAN PATENT APPLICATION

(11) **EP 1 217 657 A1**
(43) Date of publication of application: **26.06.2002**
(21) Application number: 00128017.1
(22) Date of filing: 20.12.2000
(51) Int. Cl.: H01L 21/8242

(54) **Method of forming a buried strap in a dram cell**

(71) Applicant: Semiconductor 300 GmbH & Co. KG, 01074 Dresden (DE)
(72) Inventor: Drabe, Christian, 01099 Dresden (DE); Zehner, Sigurd, 01099 Dresden (DE)
(74) Representative: Fischer, Volker, Dipl.-Ing.

(57) **Abstract**

The present invention refers to the field of dynamic random access memories (DRAMs), and, in particular, to a method for making an electrical connection between a trench storage capacitor and an access transistor.

The method of the present invention comprises the steps of preparing said semiconductor substrate, providing at least one isolating layer on said substrate, providing a deep trench (2) in said semiconductor substrate, forming a trench capacitor in a lower part of said deep trench, said trench capacitor having a trench center electrode (15) surrounded by an isolating material, filling said trench with a conductive material, the lower part of said conductive material being isolated from said semiconductor substrate by an isolating collar (4), defining an active area of said DRAM cell, said active area being adjacent to one side of said deep trench, forming a transistor in said active area with an electrode extending to make electrical contact with said conductive material in said deep trench (2), wherein the uppermost part of said conductive material in said trench, said uppermost part being at the same level as the isolating layer, is recessed to form a buried strap (5) after lithographically defining said active area.

## Description

The present invention generally refers to the field of dynamic random access memories (DRAMs), and more specifically to a process of making an electrical connection between a trench storage capacitor and an access transistor.

Dynamic random access memory (DRAM) cells are composed of two main components, a storage capacitor for storing the charge and an access transistor for transferring charge to or from the capacitor. The capacitor may be either arranged on the substrate surface or in a trench which is etched into the semiconductor substrate. In order to meet the demands of the semiconductor industry for an ever decreasing chip size coupled with a constant memory storage capacity the trench capacitor layout is clearly favored because this particular setup results in a reduction in the space required for the capacitor without sacrificing capacitance.

A very important and delicate element in the DRAM cell is the electrical connection made between the trench capacitor and the access transistor. Such a contact is often referred to in the art as a self-aligned conductive strap. This strap may be on the surface or may be buried, and it is formed at the intersection of the storage trench and the junction of the array device. During one or more thermal processing steps, dopants from the highly doped polysilicon fill in the storage trench are outdiffused into the substrate from which the trench was cut.

One such method for preparing a self-aligned buried strap in a 256 MB DRAM cell is illustrated in U.S. Pat. No. 5,360,758 entitled "SELF-ALIGNED BURIED STRAP FOR TRENCH TYPE DRAM DEVICES" issued to Bronner et al.

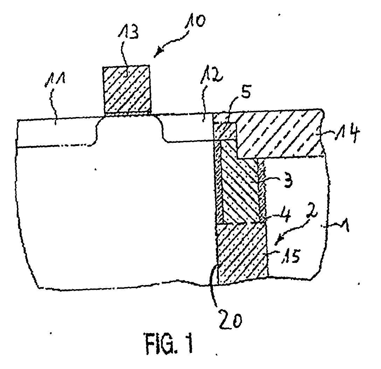

Figure 1 shows a portion of an exemplary DRAM cell formed in a substrate 1 wherein the buried strap 5 is formed according to the method described in U.S. Pat. No. 5,360,758. A field-effect transistor denoted generally by numeral 10 has a source 11 and a drain 12 controlled by gate 13 as is conventional. On the right of the drawing, a trench capacitor is formed as is known in the art by etching a deep trench 2 down into the substrate 1, forming an insulator along the trench surface (typically silicon dioxide and/or silicon nitride), filling it with doped polysilicon 15 up to a first level, then adding an isolating collar 4 of some convenient dielectric such as silicon dioxide or silicon nitride.

The center portion is then filled with a second layer of conductive polysilicon 3. The conductive polysilicon 3 as well as the insulating collar 4 are recessed. Subsequently, the trench is filled with a third layer of strap material 5 which is normally doped polysilicon. The strap 5 which is shown at the top of electrode 3 connects center electrode 15 to drain 12. An isolating material 14 in the form of silicon dioxide filling a shallow trench is shown to the right of the transistor. The shallow trench isolation also extends behind and in front of the plane of the paper in order to isolate the DRAM cell. The active area is the part of the surface of the DRAM cell which is not covered by this isolating material 14. The transistor is formed in the active area.

The main steps of forming the buried strap as well as defining the active area in a conventional process known to the inventors are shown in Figures 6 to 9.

Referring to Figure 6, there is shown the trench 2 after depositing the third layer 5 of conductive polysilicon. For forming the buried strap, after recessing the second layer 3 of conductive polysilicon and the isolating collar 4, the trench 2 is completely filled up with the third layer 5 of conductive polysilicon. Then, the conductive polysilicon 5 is recessed down to or slightly below the level of the silicon substrate surface. A typical recess depth amounts to approximately 185 nm since the thickness of the isolating coating 8 on the substrate is about 135 nm and the level of the recessed conductive polysilicon 5 is about 50 nm beneath the level of the silicon substrate.

Before coating a resist layer 7 for lithographically defining the active area, the substrate surface is planarized by applying a filling material 9 followed by a layer of antireflective coating 6 so that the lithography can properly be performed. Typical filling materials comprise for example boronsilicate glass which is applied by chemical vapour deposition. As an antireflective coating (ARC), which is applied in an appropriate thickness so as to additionally planarize the substrate surface, polymers, resist materials or other organic materials similar to resist materials can be used. Alternatively, such an antireflective material can also be used as the filling material itself.

After applying the filling material 9 and the antireflective coating layer 6, the resist layer 7 for lithographically defining the active area is applied.

Referring to Figure 7, there is shown the trench 2 after lithographically patterning the resist layer 7. In a following step, the isolation trench 17 for shallow trench isolation is etched as is shown in Figure 8. The etching depth amounts to the depth of the shallow trench isolation depth which is approximately 290 nm in the present case and the terminating point of this etching process is controlled by measuring the etching depth using an atomic force microscope.

In a following step, the resist 7 is stripped as is shown in Figure 9, and the process of defining the buried strap as well as the isolation trenches for shallow trench isolation is completed. Thereafter, an isolating material 14 will be filled into the isolation trench.

One disadvantage of this process is that a large thickness of planarizing material has to be filled into the recessed trench in order to planarize the surface of the substrate. During the etching step for etching the isolation trenches, this large thickness must be etched. However, any etching process will also attack the resist layer. Hence, also a thick layer of resist material will be necessary, in order to make sure that a sufficient thickness of the photoresist material will remain after this etching step. However, a thick layer of photoresist material is disadvantageous when performing the lithography.

Moreover, when the material to be filled into the recess is boronsilicate glass, an additional chemical vapour deposition step is necessary and a removal afterwards.

It is therefore an object of the present invention to provide an improved method of forming a DRAM cell which has overcome the above disadvantages.

According to the present invention, the above object is achieved by a method of forming a DRAM cell comprising a trench capacitor in a semiconductor substrate and an access transistor connected thereto, comprising the steps of preparing said semiconductor substrate, providing at least one isolating layer on said substrate, providing a deep trench in said semiconductor substrate, forming a trench capacitor in a lower part of said deep trench, said trench capacitor having a trench center electrode surrounded by an isolating material, filling said trench with a conductive material, the lower part of said conductive material being isolated from said semiconductor substrate by an isolating collar, defining an active area of said DRAM cell, said active area being adjacent to one side of said deep trench, forming a transistor in said active area with an electrode extending to make electrical contact with said conductive material in said trench, wherein the uppermost part of said conductive material in said trench, said uppermost part being at the same level as the isolating layer, is recessed to form a buried strap after lithographically defining said active area.

The preferred embodiments are defined in the dependent claims.

As described above, in contrast to the known techniques, the uppermost part of the conductive material in the trench is recessed after the active area is defined. In this respect, the uppermost part of the conductive material refers to the top of the conductive material when the trench is completely filled up with the conductive material. In greater detail, the resist material for lithographically patterning the isolation trenches is applied and patterned before any strap material is recessed.

As a consequence, the step of planarizing the surface of the substrate and filling the recess with a filling material is not necessary, and, additionally, when etching the active area, the filling material need not to be etched.

Accordingly, by simply changing the order of processing steps, a variety of advantages is achieved.

In particular, the present invention provides the following advantages:
- Since the strap material is recessed after etching the isolation trenches, it is not necessary to planarize the substrate surface with a filling material before the isolation trenches are lithographically patterned.
- Accordingly, the step of depositing the filling material can be omitted.
- Additionally, less organic antireflective coating is needed.
- As a consequence, it is not necessary to etch such a thick planarizing layer and, hence, the thickness of the resist material can be reduced.
- Accordingly, the lithography of the active area will be improved and, in particular, the process window for the lithography will be largely improved.
- Since the step of applying the filling material is omitted, the process will be greatly simplified, whereby cost and cycletime will be reduced.
- The step of determining the recess depth using an AFM is omitted or can be replaced by a profiler measurement after finishing, whereby the method of the invention becomes faster and cheaper.
- The filling material does not need to be removed.

The present invention will be described in more detail with reference to the accompanying drawings.
- Figure 1: is a schematic drawing representing a DRAM cell having a buried strap;
- Figure 2: is a schematic drawing representing the trench after lithographically defining the active area in the method of the present invention;
- Figure 3: is a schematic drawing representing the trench after etching the active area in the method of the present invention;
- Figure 4: is a schematic drawing representing the trench after the resist strip in the method of the present invention;
- Figure 5: is a schematic drawing representing the trench after the postponed recess etch in the method of the present invention;
- Figure 6: is a schematic drawing representing the trench after depositing the strap material in the prior art method;
- Figure 7: is a schematic drawing representing the trench after lithographically defining the active area in the prior art method;
- Figure 8: is a schematic drawing representing the trench after etching the active area in the prior art method;
- Figure 9: is a schematic drawing representing the trench after the resist strip in the prior art method; and
- Figure 10: is a schematic plan view of a commonly known DRAM cell which is manufactured by the process of the present invention.

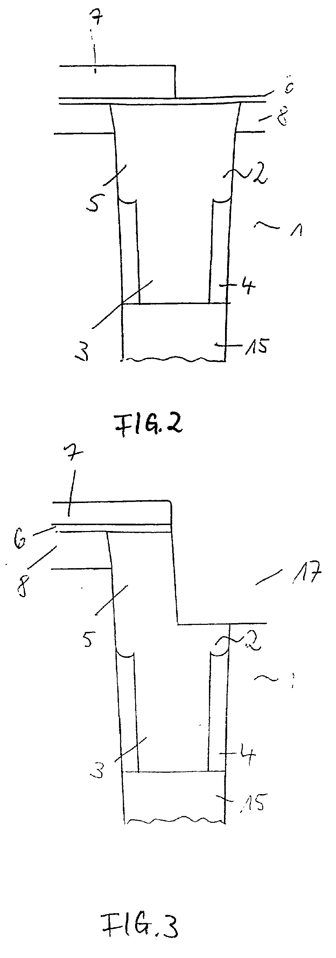

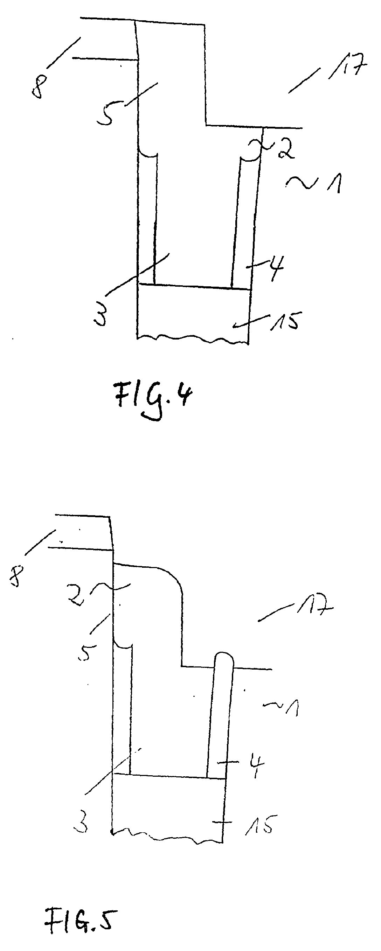

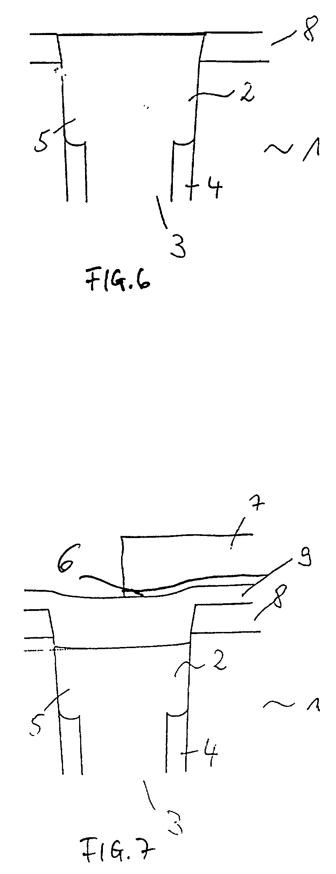

Referring to Figure 2, there is shown a portion of a DRAM cell formed in the semiconductor substrate 1 which is isolated by a thin silicon dioxide layer and a 150 nm silicon nitride layer 8. A deep trench 2 is filled with a center electrode material 15, which is usually doped polysilicon. The center electrode 15 is isolated from the substrate by a dielectric such as silicon dioxide, silicon nitride or a layered structure of silicon nitride/silicon dioxide or silicon dioxide/silicon nitride/silicon dioxide (20 in figure 1). After forming the center electrode, an isolating collar 4 of a suitable dielectric such as silicon dioxide or silicon nitride is formed, and the conductive polysilicon 3 is filled into the center portion of the isolating collar 4.

The deep trench 2 is filled up with the strap material 5, which is usually doped polysilicon, for instance arsenic doped polysilicon, which is formed by a low pressure chemical vapor deposition. After filling up the deep trench 2 with the strap material 5, the substrate surface is planarized, for example, by Chemical Mechanical Polishing or by plasma etching.

In contrast to the known methods, at this point, the strap material 5 is not recessed, i.e. the whole surface of the strap material remains at the same level as the isolating layer 8. Instead, the entire surface of the substrate including the deep trench 2 is coated with an antireflective coating 6 which normally is made of an organic material. Additionally, the resulting surface is covered by a resist layer 7 which is patterned by employing the methods commonly known in the art (photolithography).

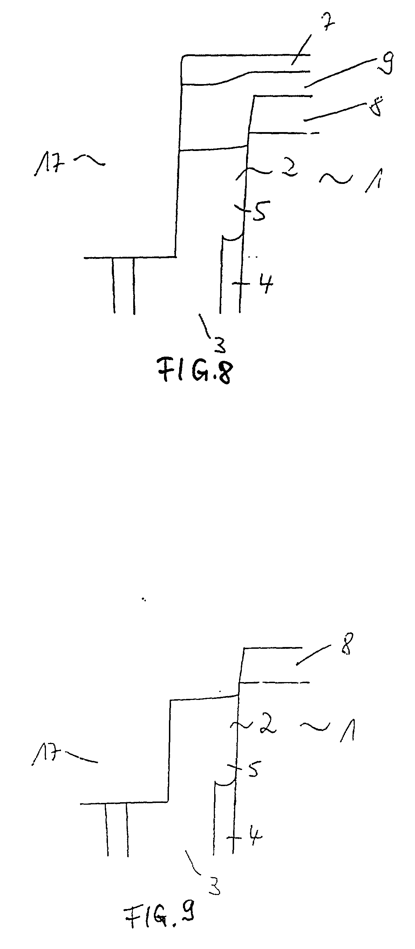

As is shown in Figure 3, an isolation trench 17 for shallow trench isolation now is etched. Thereby, also the active area of the DRAM cell is defined. This etching step, during which the patterned resist layer serves as an etching mask, may be divided into several sub-steps. Accordingly, the etching gases and parameters can suitably be adjusted for every sub-step.

In a first sub-step, the antireflective coating is completely etched. In a second sub-step, the mask is opened. In greater detail, in this step the isolating layer 8 (including the silicon dioxide layer and the silicon nitride layer) as well as the silicon 5 in the trench are anisotropically etched selectively with respect to the resist material. The etching time is selected so that the part of the isolating layer 8, which is not covered with resist material, is completely removed. In a third sub-step, the main etch is performed. In this sub-step, the silicon in the trench and in the substrate are anisotropically etched selectively with respect to the resist material.

The etching depth of the etching step illustrated in Figure 3, in particular of the third sub-step, is defined by the target depth of the shallow trench isolation minus the depth of the recess which is to be formed in the strap material 5.

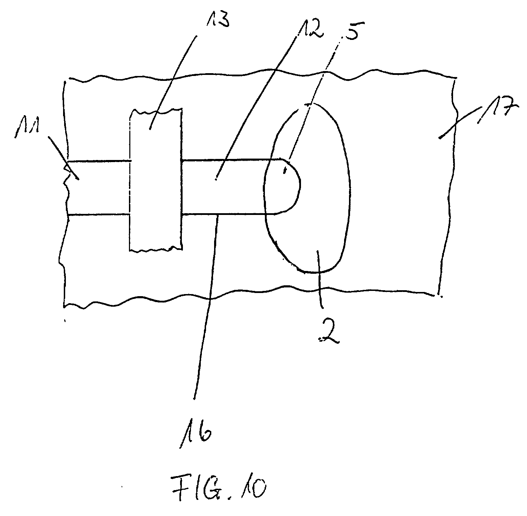

In the following step, the resist is stripped from the substrate surface, as is shown in Figure 4.

Then, as is shown in Figure 5, the shallow trench and the buried strap are etched to the final depth. During this etching step, the silicon in the trench and in the substrate are anisotropically etched. The remaining part of the silicon nitride layer 8 serves as an etching mask. Stated more concretely, the whole surface of the conductive material is etched down to a depth at which the part of the conductive material 5, which was covered with the resist material in Figure 3, now is below the lower edge of the substrate. Accordingly, a buried strap is formed. At the final depth the part of the conductive material 5, which was not covered with the resist material in Figure 3, now is recessed so that a part of the isolation collar 4 is exposed. Hence, an isolating trench 17 is formed in the substrate 1.

The single etching steps are standard etching steps for etching the respective materials selectively. Accordingly, the etching agents and parameters are chosen in accordance with the etching agents and parameters generally known in the art.

The final depth of the etching process can then be determined using a profilometer or by any other method known in the art.

Thereafter, the isolation trench is filled with an isolating material 14 as is commonly known in the art.

Figure 10 is a schematic plan view of the DRAM cell which corresponds to the commonly known DRAM cell design. As can be seen, the active area 16 is adjacent to one side of the deep trench 2, and the remaining parts of the deep trench are surrounded by the isolation trench 17 which is filled with the isolating material 14. Thereby, an electric isolation of the DRAM cell is accomplished. The contour of the deep trench can be arbitrary and is not limited to be elliptic.

After the isolation trench 17 has been filled with the isolating material 14, the transistor 10 comprising gate 13, source 11 and drain 12 is formed in the active area 16 in a conventional manner. In particular, the drain 12 is formed so as to be in contact with the buried strap 5.

During the thermal processing steps conducted after the deposition of the conductive material 5 in the deep trench 2, dopants from this conductive material 5 diffuse out. Thereby, among others, the electrical connection between drain and buried strap is implemented. In Figure 10, the effects of this outdiffusion are neglected.

After forming the transistor 10, the DRAM cell is finished by the conventional methods.

### Bezugszeichenliste

- 1: Substrate
- 2: Deep Trench
- 3: Conductive Polysilicon
- 4: Isolating Collar
- 5: Buried Strap
- 6: Antireflective Coating Layer
- 7: Resist Layer
- 8: Isolating Layer(s)
- 9: Filling Material
- 10: Transistor
- 11: Source
- 12: Drain
- 13: Gate
- 14: Isolating Material
- 15: Trench Capacitor Center Electrode
- 16: Active Area
- 17: Isolation Trench

## Claims

1. A method of forming a DRAM cell comprising a trench capacitor in a semiconductor substrate (1) and an access transistor (10) connected thereto, comprising the steps of
- preparing said semiconductor substrate (1);
- providing at least one isolating layer (8) on said substrate (1) ;
- providing a deep trench (2) in said semiconductor substrate (1);
- forming a trench capacitor in a lower part of said deep trench (2), said trench capacitor having a trench center electrode (15) surrounded by an isolating material (20);
- filling said deep trench (2) with a conductive material (3, 5), the lower part of said conductive material (3) being isolated from said semiconductor substrate (1) by an isolating collar (4);
- defining an active area (16) of said DRAM cell, said active area (16) being adjacent to one side of said deep trench (2);
- forming a transistor (10) in said active area with an electrode (12) extending to make electrical contact with said conductive material (5) in said trench (2),
**characterized in that** the uppermost part of said conductive material in said trench (2), said uppermost part being at the same level as the isolating layer, is recessed to form a buried strap (5) after lithographically defining said active area.

2. The method according to claim 1,
**characterized in that** the step of defining said active area comprises the step of lithographically patterning a photoresist material (7) so that part of said trench (2) is covered by said photoresist material (7) and the other part remains uncovered.

3. The method according to claim 2,
**characterized in that** the step of recessing the uppermost part of said conductive material (3, 5) comprises a first etching step for etching the exposed surface of said conductive material (5), a resist strip step for removing said photoresist material (7), as well as a second etching step for etching the whole surface of said conductive material (3, 5) down to a depth at which one part of said conductive material (5) is below the substrate (1) surface to form a buried strap, said part being adjacent to said active area of said DRAM cell, and the other part of said conductive material is recessed so that a part of said isolating collar (4) is exposed.

4. The method of claim 3,
**characterized in that** during said first and said second etching steps isolation trenches for shallow trench isolation are etched.

5. The method of claim 4,
**characterized in that** during said first etching step the etching depth is equal to the target depth of the shallow trench isolation minus the depth of the recess which is to be formed in the conductive material (5) in said trench.
